# EUROPÄISCHE PATENTSCHRIFT

(11) **EP 0 743 716 B1**
(45) Veröffentlichungstag und Bekanntmachung des Hinweises auf die Patenterteilung: **27.02.2002**
(21) Anmeldenummer: 96107103.2
(22) Anmeldetag: 06.05.1996
(51) Int. Cl.: H01R 12/22, H01R 12/04, H01R 12/32, H05K 3/34

(54) **Elektronisches Bauteil für Oberflächenmontage (SMT)**
Electronic component for surface mounting (SMT)
Composant électronique pour le montage en surface (SMT)

(30) Priorität: 16.05.1995 DE 19517977
(43) Veröffentlichungstag der Anmeldung: 20.11.1996
(73) Patentinhaber: OTTO DUNKEL GMBH FABRIK FÜR ELEKTROTECHNISCHE GERÄTE, 84453 Mühldorf (DE)
(72) Erfinder: Oberstarr, Reinhard, 84570 Polling (DE)
(74) Vertreter: Patentanwälte Leinweber & Zimmermann

(56) Entgegenhaltungen:
- DE-A- 2 343 235
- US-A- 4 889 277
- US-A- 5 096 440
- US-A- 5 213 515

## Beschreibung

Die Erfindung betrifft ein elektronisches Bauteil für Oberflächenmontage (SMT) mit einem aus einem elektrisch isolierenden Material gebildeten Trägerelement und mindestens einem daran festgelegten, einen außerhalb des Trägerelements freiliegenden, der Verbindung des elektronischen Bauteils mit einer Leiterplatte dienenden Kontaktbereich aufweisenden Leiterelement aus elektrisch leitendem Material.

Zum Verbinden elektronischer Bauteile mit einer Leiterplatte werden die Kontaktbereiche der Leiterelemente üblicherweise durch in der Leiterplatte vorgesehene Bohrungen gesteckt und darin eingelötet.

Zur Vereinfachung der automatischen Bestückung von Leiterplatten mit elektronischen Bauteilen wurde in den vergangenen Jahren als Ersatz für die herkömmliche Einlöttechnik die sogenannte Oberflächen-Löttechnik (Surface mount technology SMT) entwickelt. Bei dieser Technik werden die Kontaktbereiche der Leiterelemente auf einen üblicherweise mit einer Lötpaste bedeckten Oberflächenbereich der Leiterplatte aufgesetzt. Anschließend wird die Lötpaste zur Herstellung einer Verbindung zwischen dem elektronischen Bauteil und der Leiterplatte mittels Infrarotstrahlung aufgeschmolzen. Dieses Verfahren wird als Reflow-Verfahren bezeichnet. Daneben kann auch ein Dampfphasenlötverfahren eingesetzt werden, bei dem das ganze Bauteil in einen mit einem Lösungsmittel und Dampf gefüllten Raum gebracht wird und die Kondensationswärme beim Niederschlag des Dampfes an den kalten Bauteilen das Löten bewirkt. Dieses Verfahren ist jedoch unter Umweltgesichtspunkten bedenklich. Das Reflow-Verfahren wird nachstehend unter Bezugnahme auf Fig. 3 der beiliegenden Zeichnung erläutert.

Anhand der Fig. 3a wird das Verbinden eines elektronischen Bauteils in Form eines Steckverbinders mit einer Leiterplatte 230 beschrieben. Der Steckverbinder besteht aus einem Trägerelement 210 aus isolierendem Material mit einem plattenförmigen Boden 212 und einem sich senkrecht dazu erstreckenden Rand 214 sowie zwei den Boden 212 vollständig durchdringenden Leiterelementen 220. Die Leiterelemente weisen an einer Seite des Trägerelements 210 einen freiliegenden Kontaktbereich 222 und an einer dem Kontaktbereich 222 abgewandten Seite des Trägerelementes 210 einen in eine Kontaktbuchse einführbaren stiftförmigen Steckbereich 224 auf.

Zum Verbinden der Steckverbindung mit der Leiterplatte 230 werden die Kontaktbereiche 222 auf mit einer Lötpaste versehene Bereiche der Leiterplatte 230 aufgesetzt und anschließend wird die Lötpaste mittels auf die Kontaktbereiche in den durch die Pfeile 226 bezeichneten Richtungen eingestrahlter Infrarotstrahlung aufgeschmolzen. Nach Erstarren der aufgeschmolzenen Lötpaste ergibt sich so eine feste Verbindung zwischen der Leiterplatte 230 und dem Steckverbinder.

Zur Vermeidung einer die Einstrahlung des Infrarotlichtes auf die Kontaktbereiche verhindernden Schattenbildung wurde vorgeschlagen, das Trägerelement 210 im Bereich des Überganges zwischen dem plattenförmigen Boden 212 und dem sich senkrecht dazu erstreckenden Rand 214 mit Abschrägungen 218 zu versehen, wie in Fig. 3b angedeutet. Dieser Stand der Technik ist beispielsweise der DE 42 03 605 A1 entnehmbar. Dadurch wird bei ansonsten gleichbleibender Geometrie der maximale Einfallswinkel α zwischen der Leiterplatte 230 und der ohne Schattenbildung auf die Kontaktbereiche 222 einstrahlbaren Infrarotstrahlung vergrößert. Mit dieser Maßnahme kann die Dichte auf einer Leiterplatte mittels der Oberflächen-Löttechnik anbringbarer elektronischer Bauteile erhöht werden, weil durch die Erhöhung des maximalen Einfallswinkels mittels der abgeschrägten Randbereiche 218 eine Verringerung des zur Vermeidung einer Schattenbildung durch benachbarte Bauteile einzuhaltenden Mindestabstandes zwischen den einzelnen auf einer Leiterplatte anzubringenden Bauteilen erreicht werden kann.

Wenngleich die Bestückungsdichte der Leiterplatten dadurch wesentlich erhöht werden kann, sind dem maximalen Einfallswinkel α und daher auch der maximal erreichbaren Bestückungsdichte bei beispielsweise durch die Form des Randes 214 vorgegebener Geometrie der elektronischen Bauteile prinzipielle Grenzen gesetzt. Ferner ergibt sich bei der herkömmlichen Anordnung von mittels der Oberflächen-Löttechnik auf einer Leiterplatte festlegbaren elektronischen Bauelementen das Problem, daß der Winkelbereich, unter dem Infrarotlicht auf die Kontaktbereiche einstrahlbar ist, bei ansteigender Bestückungsdichte geringer wird, was bei einer vorgegebenen Infrarot-Lichtquelle eine Verringerung der zum Aufschmelzen zur Verfügung stehenden Infrarotleistung und folglich eine Erhöhung der zum Aufschmelzen benötigten Zeit zur Folge hat.

Angesichts der vorstehend beschriebenen Probleme im Stand der Technik besteht die Aufgabe dieser Erfindung in der Bereitstellung eines elektronischen Bauteils, das mittels der Oberflächenlöttechnik selbst bei einer hohen Bestückungsdichte rasch mit einer Leiterplatte verbindbar ist.

Zur Lösung dieser Aufgabe zeichnet sich das erfindungsgemäße elektronische Bauteil im wesentlichen dadurch aus, daß in dem Trägerelement mindestens ein Fenster vorgesehen ist, durch das Infrarotstrahlung auf den Kontaktbereich einstrahlbar ist.

Durch die Bildung des Fensters im Trägerelement des elektronischen Bauteils wird erreicht, daß die Infrarotstrahlung beim Reflow-Verfahren ohne Schattenbildung durch das Trägerelement hindurch auf den Kontaktbereich eingestrahlt werden kann. Daher kann selbst senkrecht auf die Leiterplatte einfallendes Infrarotlicht ohne Schattenbildung auf den Kontaktbereich eingestrahlt werden. Dadurch kann eine das zur Herstellung der Verbindung zwischen dem elektronischen Bauteil und der Leiterplatte notwendige Aufschmelzen der Lötpaste beeinflussende Schattenbildung durch benachbarte elektronische Bauteile und somit auch eine Herabsetzung der zum Aufschmelzen zur Verfügung stehenden Infrarotleistung durch diese benachbarten Bauteile ausgeschlossen werden. Folglich kann bei Verwendung erfindungsgemäßer elektronischer Bauteile eine lediglich durch die Geometrie der Bauteile selbst begrenzte Bestückungsdichte einer Leiterplatte verwirklicht werden, ohne daß dadurch eine Erhöhung der zur Herstellung der Verbindung der elektronischen Bauteile mit der Leiterplatte zur Verfügung zu stellenden Zeit erforderlich wird. Ferner erlaubt das erfindungsgemäße Bauteil auch dann den Einsatz des Reflow-Verfahrens zur Herstellung einer Verbindung mit der Leiterplatte, wenn die Außenabmessungen des Bauteils vorgegeben sind und eine Verbindung mit innerhalb dieser Außenabmessungen unterhalb des Bauteils vorgegebenen Leiterbahnen herzustellen ist. Das kann beispielsweise bei einem Bauteil in Form eines Steckverbinders der Fall sein.

Das Fenster kann besonders einfach in Form einer das Trägerelement durchsetzenden Ausnehmung gebildet werden. Zum Schutz des Kontaktbereichs ist jedoch auch daran gedacht, das Fenster in Form eines für Infrarotlicht transparenten, festen Materials auszubilden.

Ein erfindungsgemäßes elektronisches Bauteil in Form eines Steckverbinders zeichnet sich im wesentlichen dadurch aus, daß das Leiterelement das Trägerelement zur Bildung des Kontaktbereichs an einer Seite des Trägerelementes sowie eines freiliegenden Kontaktteils an einer dem Kontaktbereich abgewandten Seite des Trägerelements vollständig durchdringt. Der Kontaktteil kann dabei zum Einführen in eine Kontaktbuchse stiftförmig gebildet sein. Andererseits ist auch daran gedacht, den Steckbereich zum Aufnehmen eines Steckers selbst buchsenförmig zu bilden. Schließlich ist auch an den Einsatz eines zum Andrücken gegen eine weitere Leiterplatte dienenden federartigen Kontaktteils gedacht.

Zur Vermeidung der Einstrahlung von Infrarotlicht auf einen nicht zu erwärmenden Bereich der Leiterplatte kann das Fenster einen sich in Richtung auf den Kontaktbereich verringernden Querschnitt aufweisen.

Eine besonders zuverlässige Verbindung des elektronischen Bauteils mit der Leiterplatte kann erreicht werden, wenn das Trägerelement im Bereich des Fensters im wesentlichen plattenförmig gebildet ist und der Kontaktbereich sich parallel zum plattenförmigen Bereich des Trägerelements erstreckt.

Bei geeigneter Anordnung des Kontaktbereichs bezüglich des Fensters kann dadurch erreicht werden, daß senkrecht zum plattenförmigen Bereich des Trägerelementes einfallende Infrarotstrahlung auf den Kontaktbereich einstrahlbar ist.

In besonders vorteilhafter Ausgestaltung der Erfindung ist an dem Trägerelement eine Anzahl zeilen- oder rasterartig angeordneter, jeweils einen außerhalb des Trägerelementes freiliegenden Kontaktbereich aufweisender Leiterelemente festgelegt, wobei auf jeden Kontaktbereich Infrarotstrahlung durch ein Fenster im Trägerelement einstrahlbar ist.

Die Verbindung des elektronischen Bauteils mit der Leiterplatte kann dabei besonders zuverlässig gebildet werden, wenn jedem Kontaktbereich ein Fenster zugeordnet ist.

Zur Positionierung des erfindungsgemäßen elektronischen Bauteils bezüglich der Leiterplatte und zur Aufnahme von die Kontaktbereiche beaufschlagenden Querkräften ist es besonders bevorzugt, wenn an der dem Kontaktbereich zugewandten Seite des Trägerelementes mindestens ein Führungselement vorgesehen ist. Dieses Führungselement kann eine der Aufnahme eines an der Leiterplatte festgelegten Führungsstifts dienende Ausnehmung oder ein in eine in der Leiterplatte vorgesehene Ausnehmung einführbarer Führungsstift sein.

Nachstehend wird die Erfindung unter Bezugnahme auf die Zeichnung, auf die hinsichtlich aller erfindungswesentlichen, in der Beschreibung nicht näher herausgestellten Einzelheiten ausdrücklich verwiesen wird, erläutert. In der Zeichnung zeigt:
Fig. 1 ein elektronisches Bauteil in Form eines Steckverbinders gemäß einer ersten Ausführungsform der Erfindung,
Fig. 2a eine perspektivische Ansicht eines elektronischen Bauteils gemäß einer zweiten Ausführungsform der Erfindung,
Fig. 2b eine Schnittansicht des elektronischen Bauteils nach Fig. 2a und
Fig. 3 ein elektronisches Bauteil in Form eines Steckverbinders nach dem Stand der Technik.

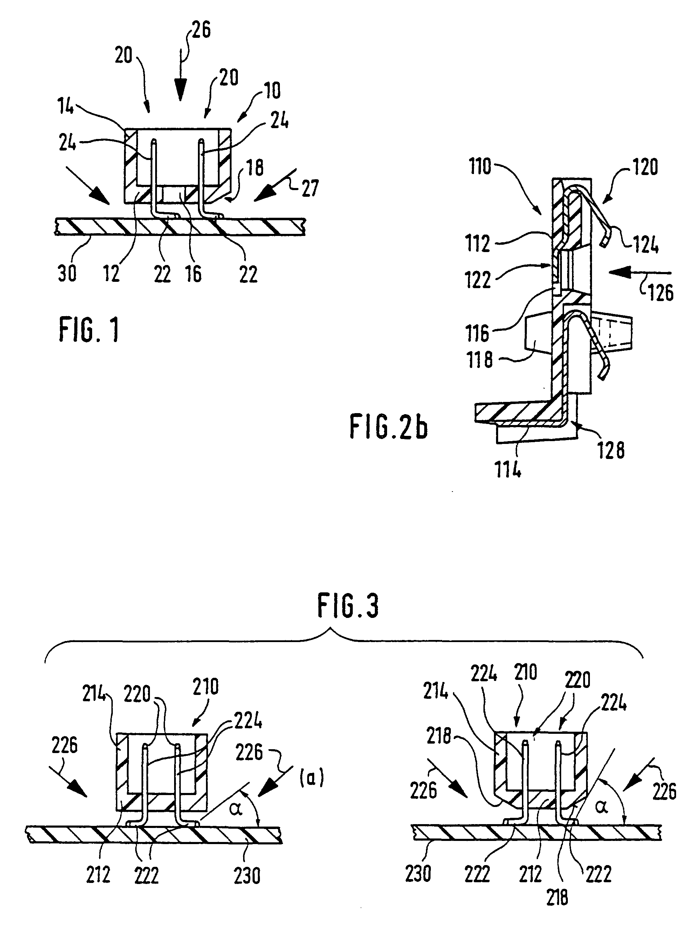

Der in Fig. 1 dargestellte Steckverbinder umfaßt ein Trägerelement 10 mit einem plattenförmigen Boden 12 und einem senkrecht dazu verlaufenden Rand 14. Der Boden ist von zwei Leiterelementen 20 vollständig durchdrungen. Jedes der Leiterelemente 20 weist an einer einer Leiterplatte 30 zugewandten Seite des Trägerelementes 10 einen Kontaktbereich 22 und an einer dem Kontaktbereich 22 abgewandten Seite des Trägerelementes 10 einen stiftförmigen Steckbereich 24 auf.

Zur Einstrahlung von Infrarotstrahlung auf den Kontaktbereich 22 eines der Leiterelemente 20 ist im Boden 12 des Trägerelementes 10 ein Fenster in Form einer den Boden durchsetzenden Ausnehmung 16 vorgesehen. Durch diese Ausnehmung ist senkrecht zur Leiterplatte 30 einfallende Infrarotstrahlung auf den Kontaktbereich 22 eines der Leiterelemente 20 einstrahlbar, wie durch den Pfeil 26 angedeutet. Zur Ermöglichung einer schattenfreien Einstrahlung von Infrarotstrahlung auf den Kontaktbereich 22 des anderen Leiterelementes 20 ist das Trägerelement 10 im Bereich des Übergangs zwischen dem Boden 12 und dem Rand 14 mit einer Abschrägung 18 versehen. Die Einfallsrichtung der auf den Kontaktbereich 22 dieses anderen Leiterelementes 20 einstrahlbaren Infrarotstrahlung ist durch den Pfeil 27 angedeutet.

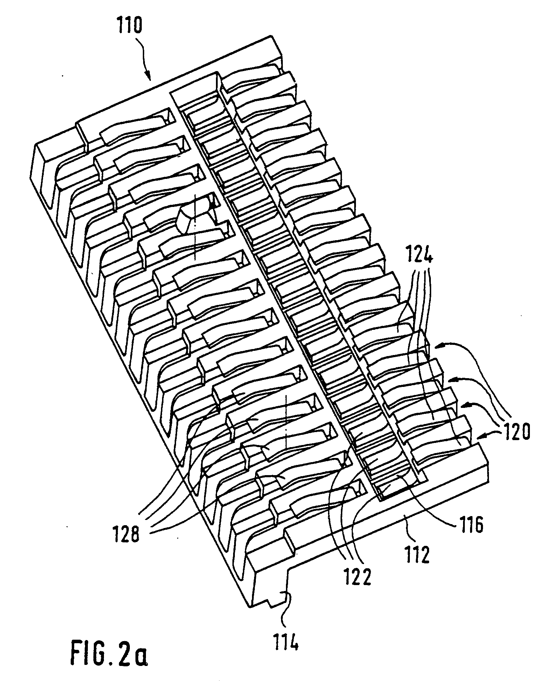

Das in Fig. 2 dargestellte elektronische Bauteil weist ein Trägerelement 110 und vierzehn an einem plattenförmigen Bereich 112 des Trägerelementes 110 längs einer Zeile festgelegte Kontaktelemente in Form auf sich selbst zurückgebogener Kontaktfedern 120 auf. Jede der Kontaktfedern 120 weist einen außerhalb des Trägerelementes 110 freiliegenden Kontaktbereich 122 sowie in eine Kontaktbuchse einführbare oder an eine weitere Leiterplatte andrückbare federartige Kontaktteile 124 auf. Der plattenförmige Bereich 112 des Trägerelementes 110 ist im Bereich der Kontaktbereiche 122 mit einer Ausnehmung 116 mit sich in Richtung auf die Kontaktbereiche verjüngendem Querschnitt durchsetzt, wie besonders deutlich der Fig. 2b zu entnehmen ist. Zur Festlegung des in Fig. 2 dargestellten elektronischen Bauteils auf einer Leiterplatte ist Infrarotstrahlung durch die Ausnehmung 116 auf die Kontaktbereiche 122 der Leiterelemente 120 einstrahlbar, wie durch den Pfeil 126 angedeutet. Eine exakte Positionierung des Bauteils auf der Leiterplatte sowie eine Sicherung des Bauteils gegen parallel zur Leiterplatte wirkende Querkräfte wird durch zwei an der der Leiterplatte zugewandten Seite des Trägerelementes 110 vorgesehene, in entsprechende Ausnehmungen in der Leiterplatte einführbare Führungsstifte 118, von denen einer in Fig. 2b dargestellt ist, gewährleistet. Wie besonders deutlich der Fig. 2a zu entnehmen ist, sind an dem Trägerelement 110 neben den Leiterelementen 120 auch noch in einen abgewinkelten Bereich 114 des Trägerelementes 110 ragende (vergleiche Fig. 2b) zeilenförmig nebeneinander angeordnete weitere Leiterelemente 128 festgelegt.

Die Erfindung ist nicht auf die anhand der Zeichnung erläuterten Ausführungsbeispiele beschränkt. Beispielsweise ist auch daran gedacht, die Leiterelemente an der dem Kontaktbereich abgewandten Seite des Trägerelementes mit einer Kontaktbuchse zu versehen. Daneben können die das Trägerelement durchsetzenden, zum Einstrahlen von Infrarotstrahlung auf die Kontaktbereiche dienenden Ausnehmungen von einem für Infrarotstrahlung transparenten festen Material abgedeckt sein.

## Patentansprüche

1. Elektronisches Bauteil für Oberflächenmontage (SMT) mit einem aus einem elektrisch isolierenden Material gebildeten Trägerelement (10, 12, 14, 110, 112, 114) und mindestens einem daran festgelegten, einen außerhalb des Trägerelementes freiliegenden, der Verbindung des elektronischen Bauteils mit einer Leiterplatte (10; 110) dienenden Kontaktbereich (22; 122) aufweisenden Leiterelement (20, 22, 24; 120, 122, 124) aus elektrisch leitendem Material, **dadurch gekennzeichnet, daß** in dem Trägerelement (10, 12, 14; 110, 112, 114) mindestens ein Fenster (16; 116) vorgesehen ist, durch das Infrarotstrahlung auf den Kontaktbereich (22; 122) einstrahlbar ist.

2. Elektronisches Bauteil nach Anspruch 1, **dadurch gekennzeichnet, daß** das Fenster in Form einer das Trägerelement (10, 110) durchsetzenden Ausnehmung (16; 116) gebildet ist.

3. Elektronisches Bauteil nach Anspruch 1 oder 2, **dadurch gekennzeichnet, daß** das Leiterelement das Trägerelement (10, 110) zur Bildung des Kontaktbereichs (22; 122) an einer Seite des Trägerelementes (10; 110) sowie eines freiliegenden Kontaktteils (24; 124) an einer dem Kontaktbereich (22; 122) abgewandten Seite des Trägerelementes (10; 110) vollständig durchdringt.

4. Elektronisches Bauteil nach Anspruch 3, **dadurch gekennzeichnet, daß** der Kontaktteil (24; 124) in eine Kontaktbuchse einführbar oder zum Andrücken an eine weitere Leiterplatte federartig gebildet ist.

5. Elektronisches Bauteil nach Anspruch 4, **dadurch gekennzeichnet, daß** der Kontaktteil (24) stiftförmig gebildet ist.

6. Elektronisches Bauteil nach Anspruch 3, **dadurch gekennzeichnet, daß** der Kontaktteil buchsenförmig gebildet ist.

7. Elektronisches Bauteil nach einem der vorhergehenden Ansprüche, **dadurch gekennzeichnet, daß** das Fenster (16; 116) einen sich in Richtung auf den Kontaktbereich (22; 122) verringernden Querschnitt aufweist.

8. Elektronisches Bauteil nach einem der vorhergehenden Ansprüche, **dadurch gekennzeichnet, daß** das Trägerelement (10; 110) im Bereich des Fensters (16; 116) im wesentlichen plattenförmig gebildet ist und der Kontaktbereich (22; 122) sich parallel zum plattenförmigen Bereich (12; 112) des Trägerelementes (10; 110) erstreckt.

9. Elektronisches Bauteil nach Anspruch 8, **dadurch gekennzeichnet, daß** senkrecht zum plattenförmigen Bereich (12; 112) des Trägerelementes (10; 110) einfallendes Infrarotlicht auf den Kontaktbereich (22; 122) einstrahlbar ist.

10. Elektronisches Bauteil nach einem der vorhergehenden Ansprüche, **dadurch gekennzeichnet, daß** an dem Trägerelement eine Anzahl zeilen- und rasterartig angeordneter, jeweils einen außerhalb des Trägerelementes freiliegenden Kontaktbereich (122) aufweisender Leiterelemente (120) festgelegt sind, wobei auf jeden Kontaktbereich (122) Infrarotstrahlung durch ein Fenster (116) im Trägerelement (110) einstrahlbar ist.

11. Elektronisches Bauteil nach Anspruch 10, **dadurch gekennzeichnet, daß** jedem Kontaktbereich (122) ein Fenster (116) im Trägerelement (110) zugeordnet ist.

12. Elektronisches Bauteil nach einem der vorhergehenden Ansprüche, **dadurch gekennzeichnet, daß** an der dem Kontaktbereich (122) zugewandte Seite des Trägerelementes (110) mindestens ein Führungselement (118) vorgesehen ist.

13. Elektronisches Bauteil nach Anspruch 12, **dadurch gekennzeichnet, daß** das Führungselement eine der Aufnahme eines an der Leiterplatte festgelegten Führungsstiftes dienende Ausnehmung ist.

14. Elektronisches Bauteil nach Anspruch 13, **dadurch gekennzeichnet, daß** das Führungselement ein in eine in der Leiterplatte vorgesehene Ausnehmung einführbarer Führungsstift (118) ist.

## Claims

1. Electronic component for surface mount technology (SMT) having a supporting element (10, 12, 14; 110, 112, 114) formed from an electrically insulating material, and at least one conducting element (20, 22, 24; 120, 122, 124), made from an electrically conductive material, which is fixed on said supporting element, and has a contact region (22; 122) which is exposed outside the supporting element and serves to connect the electronic component to a printed-circuit board (10; 110), **characterized in that** at least one window (16; 116) through which the infrared radiation can be irradiated onto the contact region (22; 122) is provided in the supporting element (10, 12, 14; 110, 112, 114).

2. Electronic component according to Claim 1, **characterized in that** the window is formed as a cutout (16; 116) penetrating the supporting element (10, 110).

3. Electronic component according to Claim 1 or 2, **characterized in that** the conducting element completely penetrates the supporting element (10, 110) to form the contact region (22; 122) on one side of the supporting element (10; 110) as well as of an exposed contact part (24; 124) on a side of the supporting element (10; 110) averted from the contact region (22; 122).

4. Electronic component according to Claim 3, **characterized in that** the contact part (24; 124) can be inserted into a contact tube, or is formed like a spring for the purpose of pressing against a further printed-circuit board.

5. Electronic component according to Claim 4, **characterized in that** the contact part (24) takes the form of a pin.

6. Electronic component according to Claim 3, **characterized in that** the contact part takes the form of a bushing.

7. Electronic component according to one of the preceding claims, **characterized in that** the window (16; 116) has a cross-section which reduces in the direction of the contact region (22; 122).

8. Electronic component according to one of the preceding claims, **characterized in that** the supporting element (10; 110) in the region of the window (16; 116) essentially takes the form of a plate, and the contact region (22; 122) extends parallel to the plate-shaped region (12; 112) of the supporting element (10; 110).

9. Electronic component according to Claim 8, **characterized in that** infrared light impinging perpendicular to the plate-shaped region (12; 112) of the supporting element (10; 110) can be irradiated onto the contact region (22; 122).

10. Electronic component according to one of the preceding claims, **characterized in that** a number of conducting elements (120) which are arranged in rows or as a grid and in each case have an exposed contact region (122) outside the supporting element are fixed on the supporting element, it being possible to irradiate infrared radiation onto each contact region (122) through a window (116) in the supporting element (110).

11. Electronic component according to Claim 10, **characterized in that** each contact region (122) is assigned a window (116) in the supporting element (110).

12. Electronic component according to one of the preceding claims, **characterized in that** at least one guide element (118) is provided on the side of the supporting element (110) facing the contact region (122).

13. Electronic component according to Claim 12, **characterized in that** the guide element is a cutout serving to receive a guide pin fixed on the printed-circuit board.

14. Electronic component according to Claim 13, **characterized in that** the guide element is a guide pin (118) which can be inserted into a cutout provided in the printed-circuit board.

## Revendications

1. Composant électronique pour montage en surface (TMS) comportant un élément support (10,12,14;110,112,114) réalisé en un matériau isolant électriquement et au moins un élément conducteur (20,22,24;120,122,124) en un matériau électriquement conducteur, fixé à l'élément support, se trouvant à découvert à l'extérieur de cet élément support, comportant une zone de contact (22; 122) servant à la liaison du composant électronique avec une plaque conductrice (30), **caractérisé par le fait qu'**est prévue dans l'élément support ((10,12,14;110,112,114) au moins une fenêtre par laquelle le rayonnement infrarouge peut irradier la zone de contact (22;122).

2. Composant électronique selon la revendication 1, **caractérisé par le fait que** la fenêtre est réalisée sous forme d'un évidement (16;116) traversant l'élément support (10, 110).

3. Composant électronique selon la revendication 1 ou 2, **caractérisé par le fait que** l'élément conducteur traverse complètement l'élément support ( 10,110 ) pour la formation de la zone de contact (22;122) d'un côté de l'élément support (10;110) ainsi que d'une partie de contact (24;124) se trouvant à découvert d'un côté de l'élément support (10,110) éloigné de la zone de contact (22;122).

4. Composant électronique selon la revendication 3, **caractérisé par le fait que** la partie de contact (24;124) est réalisée de manière à pouvoir être introduite dans une douille de contact ou est réalisée à la manière d'un ressort pour exercer une pression contre une autre plaque conductrice.

5. Composant électronique selon la revendication 4, **caractérisé par le fait que** la partie de contact (24) est réalisée en forme de broche.

6. Composant électronique selon la revendication 3, **caractérisé par le fait que** la partie de contact est réalisée en forme de douille.

7. Composant électronique selon l'une des revendications précédentes , **caractérisé par le fait que** la fenêtre (16;116) présente une section transversale diminuant en direction de la zone de contact (22;122).

8. Composant électronique selon l'une des revendications précédentes , **caractérisé par le fait que** l'élément support (10;110) est réalisé, dans la zone de la fenêtre (16;116), essentiellement en forme de plaque et que la zone de contact (22;122) s'étend parallèlement à la zone (12;112) en forme de plaque de l'élément support (10;110).

9. Composant électronique selon la revendication 8, **caractérisé par le fait que** de la lumière infrarouge tombant perpendiculairement à la zone (12;112) en forme de plaque de l'élément support (10;110) peut irradier la zone de contact (22;122).

10. Composant électronique selon l'une des revendications précédentes, **caractérisé par le fait que** sur l'élément support sont fixés un certain nombre d'éléments conducteurs (120) disposés en lignes et en réseau, comportant respectivement une zone de contact (122) se trouvant à découvert à l'extérieur de l'élément support, un rayonnement infrarouge pouvant irradier chaque zone de contact (122) à travers une fenêtre (116) dans l'élément support (110).

11. Composant électronique selon la revendication 10, **caractérisé par le fait qu'**une fenêtre (116) dans l'élément support (110) est associée à chaque zone de contact (122).

12. Composant électronique selon l'une des revendications précédentes, **caractérisé par le fait qu'**au moins un élément de guidage (118) est prévu du côté de l'élément support (110) tourné vers la zone de contact (122).

13. Composant électronique selon la revendication 12, **caractérisé par le fait que** l'élément de guidage est un évidement servant à la réception d'une broche de guidage fixée à la plaque conductrice.

14. Composant électronique selon la revendication 12, **caractérisé par le fait que** l'élément de guidage est une broche de guidage (118) apte à s'engager dans un évidement prévu dans la plaque conductrice.
